(19) Europäisches Patentamt / European Patent Office / Office européen des brevets

(11) **EP 4 400 853 A1**

(12) **EUROPEAN PATENT APPLICATION**

(43) Date of publication:
**17.07.2024 Bulletin 2024/29**

(21) Application number: **23212070.9**

(22) Date of filing: **24.11.2023**

(51) International Patent Classification (IPC):
**G01R 31/367** (2019.01)  **H01M 10/48** (2006.01)
**H01M 10/63** (2014.01)  **H01M 10/633** (2014.01)

(52) Cooperative Patent Classification (CPC):
**G01R 31/367; H01M 10/48; H01M 10/63;
H01M 10/633**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **16.01.2023 KR 20230006305**

(71) Applicant: **Samsung SDI Co., Ltd.**
**Yongin-si, Gyeonggi-do 17084 (KR)**

(72) Inventor: **CHUN, Changyoon**
**17084 Yongin-si (KR)**

(74) Representative: **Marks & Clerk LLP**
**15 Fetter Lane**
**London EC4A 1BW (GB)**

(54) **METHOD AND APPARATUS FOR ESTIMATING INTERNAL STATE OF BATTERY BY USING ELECTROCHEMICAL MODEL OF BATTERY**

(57)    A method of estimating an internal state of a battery (S110) includes acquiring at least one parameter of the battery, and estimating the internal state (S120) of the battery by using an electrochemical model based on the at least one parameter, the electrochemical model being calculated based on a single particle model (SPM) with respect to a cathode and an anode of the battery, wherein the electrochemical model includes a model configured to calculate inner lithium-ion concentrations in the cathode and the anode based on a difference between diffusion of lithium ions in the cathode and the anode of the battery and to estimate the internal state of the battery based on the difference between the inner lithium-ion concentrations in the cathode and the anode.

FIG. 6

START

MEASURE PARAMETER OF BATTERY — S110

ESTIMATE INTERNAL STATE OF BATTERY BY USING ELECTROCHEMICAL MODEL THAT IS CALCULATED BASED ON SINGLE PARTICLE MODEL WITH RESPECT TO CATHODE AND ANODE OF BATTERY — S120

END

EP 4 400 853 A1

**Description**

**BACKGROUND**

**1. Field**

Aspects of embodiments of the present disclosure relate to a method and apparatus for estimating an internal state of a battery by using an electrochemical model of the battery.

**2. Description of the Related Art**

Estimation of an internal state in a battery is one of the most important factors in battery management and control. For example, estimation of a state of charge (SOC), a state of health (SOH), a state of power, etc. is very important for monitoring and maintaining the battery performance in real-time.

For estimating an internal state of a battery, there have been attempts to numerically model a lithium-ion secondary battery and understand a movement phenomenon in the lithium-ion secondary battery in a quantitative and theoretical manner. Also, an electrochemical model such as a single particle model (SPM) has been recently used for battery research.

The above information disclosed in this Background section is only for enhancement of understanding of the background of the invention and therefore it may contain information that does not form the prior art.

**SUMMARY**

Aspects of some embodiments of the present disclosure are directed to include a method and apparatus for estimating an internal state of a battery by using an electrochemical model of a battery. However, the above technical features are merely examples, and the scope of the disclosure is not limited thereto.

Additional aspects will be set forth in part in the description which follows and, in part, will be apparent from the description, or may be learned by practice of the presented embodiments of the disclosure.

According to some embodiments of the of the present disclosure, there is provided a method of estimating an internal state of a battery, the method including: acquiring at least one parameter of the battery; and estimating the internal state of the battery by using an electrochemical model based on the at least one parameter, the electrochemical model being calculated based on a single particle model (SPM) with respect to a cathode and an anode of the battery, wherein the electrochemical model includes a model configured to calculate inner lithium-ion concentrations in the cathode and the anode based on a difference between diffusion of lithium ions in the cathode and the anode of the battery and to estimate the internal state of the battery based on the difference between the inner lithium-ion concentrations in the cathode and the anode.

In some embodiments, the at least one parameter includes at least one of a voltage, a current, and a temperature of the battery.

In some embodiments, the electrochemical model includes a model configured to calculate inner lithium-ion concentrations in the cathode and the anode of the battery by discretizing the SPM with respect to the cathode and the anode of the battery into spheres each having a plurality of layers.

In some embodiments, the electrochemical model includes a model configured to calculate the inner lithium-ion concentrations in the cathode and the anode of the battery based on a diffusion coefficient according to concentration distributions in the cathode and the anode of the battery, and the diffusion coefficient is based on a concentration and a temperature of each layer from among the plurality of layers in the SPMs for the cathode and the anode of the battery.

In some embodiments, the electrochemical model includes a model that estimates a voltage of the battery based on an overpotential value defined as a difference between a measured voltage of the battery and an open-circuit voltage (OCV) of the battery.

In some embodiments, the electrochemical model includes a model configured to calculate a priori overpotential value based on information about lithium-ion concentration in an outermost layer from among the plurality of layers in the SPMs of the cathode and the anode of the battery, information about an average lithium-ion concentration in the cathode and the anode of the battery, and voltage drop information of the battery, and to calculate the overpotential value based on the priori overpotential value and an overpotential proportional coefficient.

In some embodiments, the overpotential proportional coefficient is an experimental value that simulates a relationship between the priori overpotential value and the overpotential value in a Butler-Volmer equation by using curve fitting.

According to some embodiments of the of the present disclosure, there is provided a computer-readable program stored in a recording medium for executing the method described above by using a computing device.

According to some embodiments of the of the present disclosure, there is provided an apparatus for estimating an internal state of a battery, the apparatus including: a memory configured to store data that is generated by measuring at least one parameter of the battery; and a processor configured to estimate the internal state of the battery by using an electrochemical model that is calculated based on a single particle model (SPM) with respect to a cathode and an anode of the battery based on the at least one parameter, wherein the electrochemical model includes a model configured to calculate inner lithium-ion concentrations in the cathode and the anode based on a difference between diffusion of lithium ions in the cathode and the anode of the battery and estimates the internal state of the battery based on the difference between the inner lithium-ion concentrations in the cathode and the anode.

In some embodiments, the at least one parameter includes at least one of a voltage, a current, and a temperature of the battery.

In some embodiments, the electrochemical model includes a model that calculates inner lithium-ion concentrations in the cathode and the anode of the battery by discretizing the SPM with respect to the cathode and the anode of the battery into spheres each having a plurality of layers.

In some embodiments, the electrochemical model includes a model configured to calculate the inner lithium-ion concentrations in the cathode and the anode of the battery based on a diffusion coefficient according to concentration distributions in the cathode and the anode of the battery, and the diffusion coefficient is based on a concentration and a temperature of each layer from among the plurality of layers in the SPM for the cathode and the anode of the battery.

In some embodiments, the electrochemical model includes a model that estimates a voltage of the battery based on an overpotential value that is a difference between a measured voltage of the battery and an open-circuit voltage (OCV) of the battery.

In some embodiments, the electrochemical model includes a model configured to calculate a priori overpotential value based on information about lithium-ion concentration in an outermost layer from among the plurality of layers in the SPMs of the cathode and the anode of the battery, information about an average lithium-ion concentration in the cathode and the anode of the battery, and voltage drop information of the battery, and to calculate the overpotential value by using the priori overpotential value and an overpotential proportional coefficient.

In some embodiments, the overpotential proportional coefficient is an experimental value that simulates a relationship between the priori overpotential value and the overpotential value in a Butler-Volmer equation by using curve fitting.

At least some of the above features that accord with the invention and other features according to the invention are set out in the claims.

## BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a diagram schematically showing a battery pack according to some embodiments of the present disclosure;
FIG. 2 is a diagram showing an example for describing a single particle model (SPM) of a battery according to some embodiments of the present disclosure;
FIG. 3 is a diagram for describing a change in a lithium-ion concentration in a battery according to some embodiments of the present disclosure;
FIG. 4 is a diagram for describing a method of discretizing an SPM of a battery according to some embodiments of the present disclosure;
FIG. 5 is a diagram for describing a Butler Volmer equation according to some embodiments of the present disclosure; and
FIG. 6 is a flowchart for describing a method of estimating an internal state of a battery according to some embodiments of the present disclosure.

## DETAILED DESCRIPTION

Reference will now be made in detail to some embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description.

Hereinafter, one or more embodiments of the disclosure will be described in detail with reference to accompanying drawings to the extent that one of ordinary skill in the art would be able to carry out the disclosure. However, an embodiment of the disclosure may be implemented in various manners, and is not limited to one or more embodiments of the disclosure described herein. In describing embodiments disclosed in the present specification, when it is determined that the detailed description of the related known technology may obscure the gist of the technical idea of the present disclosure, a detailed description of the known technology will be omitted. The same or similar components are denoted by the same reference numerals, and repeated descriptions thereof will be omitted.

Some embodiments of the present disclosure may be represented as functional block structures and various processing stages. Some or all of the functional blocks may be realized by any number of hardware and/or software components configured to perform the specified functions. For example, the functional blocks of the embodiments of the present disclosure may be realized by one or more microprocessors or circuit structures for performing a predetermined function. The functional blocks of the embodiments of the present disclosure may be implemented with any programming or scripting language. The functional blocks may be implemented in algorithms that are executed on one or more processors. The functions performed by the functional block of the embodiments of the present disclosure may be performed by a plurality of functional blocks, or functions performed by a plurality of functional blocks in the embodiments of the present disclosure may be performed by one functional block. Also, the embodiments of the present disclosure may employ any number of conventional techniques for electronics configuration, signal processing, data processing and/or the like.

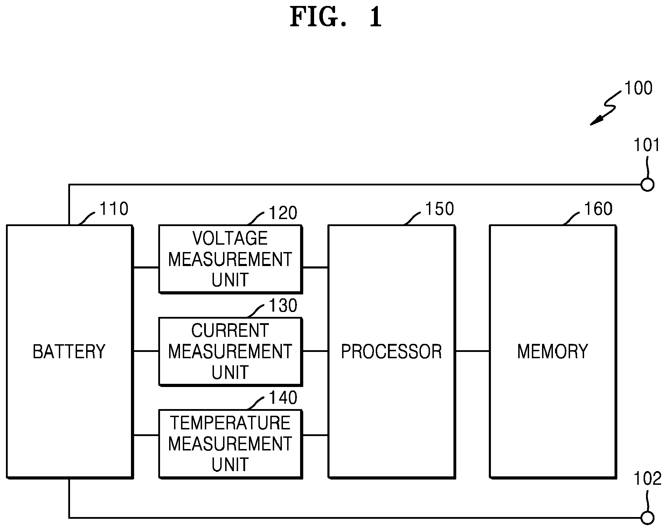

FIG. 1 is a diagram schematically showing a battery pack according to some embodiments of the present disclosure.

Referring to FIG. 1, the battery pack 100 may include a battery 110, a processor 150, a memory 160, a voltage measurement unit 120, a current measurement unit 130, and a temperature measurement unit 140.

The battery 110 may include at least one battery cell and may be a rechargeable secondary battery. For example, the battery 110 may include a lithium-ion battery.

The number of battery cells and connecting type of the battery cells may be determined based on a state of charge and a voltage requested to the battery pack 100. For example, the battery cells may be connected in parallel and/or in series to one another. FIG. 1 shows that the battery pack 100 includes one battery 110 only for the illustration purpose; however, the battery pack 100 may include a plurality of batteries 110 connected in serial, parallel, or both in serial and parallel to one another. The battery 110 may include only one battery cell or any suitable number of battery cells.

The battery 110 may include a plurality of battery modules each including a plurality of battery cells. Also, the battery pack 100 may include a pair of pack terminals 101 and 102 to which an electrical load or a charging device may be connected.

Herein, the battery that is a target of which the internal state is to be estimated may be the battery 110 or each of the at least one battery cell included in the battery 110. The method of estimating the internal state of one battery is described herein; however, embodiments of the present disclosure may be identically applied to a method of estimating the internal state of each of the plurality of battery cells included in the battery 110.

The battery pack according to some embodiments includes a switch. The switch may be connected between the battery 110 and one of the pack terminals 101 and 102 (e.g., 101). The switch may be controlled by the processor 150. The battery pack 100 may further include a battery protection circuit, a fuse, a current sensor, etc.

The apparatus for estimating the internal state of the battery, according to some embodiments, includes the processor 150 and the memory 160.

The processor 150 controls overall operations of the apparatus for estimating the internal state of the battery. For example, in order to perform the above operation, the processor 150 may be implemented to selectively include known processors in the field, an application-specific integrated circuit (ASIC), another chipset, a logic circuit, a register, a communication modem, and/or a data processing apparatus.

The processor 150 may perform basic arithmetic operations, logic operations, and input/output operations, for example, and may execute program codes stored in the memory 160. The processor 150 may store data in the memory 160 or load data stored in the memory 160.

The memory 160 is a recording medium that is readable by the processor 150 and may include a permanent mass storage device such as a random-access memory (RAM), a read only memory (ROM), and a disk drive. The memory 160 may store an operating system and at least one program or application code. The memory 160 stores a program code for estimating the internal state of the battery according to some embodiments. For example, the memory 160 may store data generated by measuring at least one parameter of the battery 110. Also, the memory 160 may store a specific capacity of the battery 110. Also, the memory 160 may store state of charge (SOC)-open circuit voltage (OCV) data of the battery 110. For example, the above data may include charging/discharging current, terminal voltage and/or temperature of the battery. Also, the above data may include a discharge rate of the battery. Program codes for estimating the SOC of the battery by using data generated by measuring at least one parameter of the battery, and the SOC-OCV data may be stored in the memory 160. At least one parameter of the battery 110 denotes a component or a variable such as a terminal voltage, charging/discharging currents, and/or peripheral temperature of the battery 110.

The apparatus for estimating the internal state of the battery may further include the voltage measurement unit 120, the current measurement unit 130, and the temperature measurement unit 140 for measuring the at least one parameter of the battery 110. The apparatus for estimating the internal state of the battery may further include a communication module for communicating with another device such as an electronic control device of a vehicle, a controller of a charging device, etc.

The voltage measurement unit 120 may be configured to measure the voltage of the battery 110. For example, as shown in FIG. 1, the voltage measurement unit 120 may be electrically connected to opposite ends of the battery 110. Also, the voltage measurement unit 120 may be electrically connected to the processor 150 so as to exchange electrical signals. In addition, the voltage measurement unit 120 may measure the voltage between the opposite ends of the battery 110 with time interval and may output a signal representing a magnitude of the measured voltage to the processor 150, under the control from the processor 150. Here, the processor 150 may determine the voltage of the battery 110 from the signal output from the voltage measurement unit 120. For example, the voltage measurement unit 120 may be implemented by using a voltage measurement circuit that is generally used in the field.

Also, the current measurement unit 130 may be configured to measure the current of the battery. For example, the current measurement unit 130 may be electrically connected to a current sensor provided on a charging/discharging passage of the battery 110. Also, the current measurement unit 130 may be electrically connected to the processor 150 so as to exchange electrical signals. Also, the current measurement unit 130 repeatedly measures the magnitude of the charging current or discharging current of the battery 110 with time intervals and outputs a signal representing the magnitude of the measured current to the processor 150, under the control from the processor 150. Here, the processor 150 may determine the magnitude of the current from the signal output from the current measurement unit 130. For example, the current sensor may be implemented by using a hole sensor, a sense resistor, or any other suitable means.

The temperature measurement unit 140 may be configured to measure the temperature of the battery. For example, as shown in FIG. 1, the temperature measurement unit 140 may be connected to the battery 110 to measure the temperature of the secondary battery provided in the battery 110. Also, the temperature measurement unit 140 may be electrically connected to the processor 150 so as to exchange electrical signals. In addition, the temperature measurement unit 140 may repeatedly measure the temperature of the secondary battery (e.g., at certain time intervals) and may output a signal representing the degree of the measured temperature to the processor 150. Here, the processor 150 may determine the temperature of the secondary battery from the signal output from the temperature measurement unit 140. For example, the temperature measurement unit 140 may be implemented by using a thermocouple or any other suitable means.

Also, the processor 150 may estimate the internal state of the battery 110 by using at least one of the voltage measurement value, the current measure value, and the temperature measurement value with respect to the battery 110 received from the voltage measurement unit 120, the current measurement value 130, and the temperature measurement unit 140. For example, the processor 150 may estimate the SOC of the battery 110. Here, the SOC may be calculated as a numerical value corresponding the remaining capacity of the battery 110, within a range from 0% to 100%.

In some embodiments, the processor 150 estimates the SOC of the battery 110 by accumulating the charging/discharging currents of the battery 110. Here, an initial value of a charging state when the charging or discharging of the battery 110 starts may be determined by using an open circuit voltage, OCV, of the battery 110, which is measured before starting the charging or discharging. To this end, the processor 150 may map the charging state to the corresponding OCV of the battery 110 from the SOC-OCV data, based on the SOC-OCV data defining the charging state for each open-circuit voltage.

In some examples, the processor 150 may estimate the SOC of the battery 110 by using an extended Kalman filter. The extended Kalman filter denotes an arithmetic algorithm that adaptively estimates the charging state of the secondary battery by using the voltage, current, and temperature of the secondary battery.

The SOC of the battery 110 may also be determined by selective utilizing the voltage, current, and temperature of the secondary battery, rather than the current accumulation method or the extended Kalman filter described above.

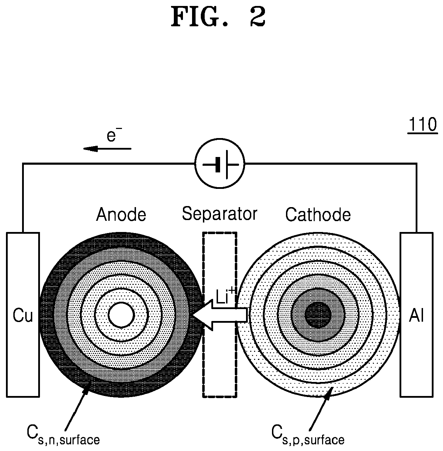

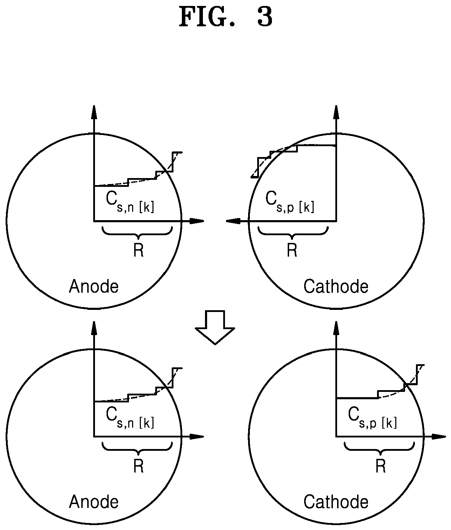

FIG. 2 is a diagram showing an example for describing a single particle model (SPM) of a battery according to some embodiments of the present disclosure. FIG. 3 is a diagram for describing a change in a lithium-ion concentration in a battery according to some embodiments of the present disclosure.

Referring to FIG. 2 and FIG. 3, in an anode of a battery, lithium ions (Li-ions) are intercalated and a concentration increases from the outermost portion during charging the battery, and in a cathode of the battery, Li-ions are discharged and the concentration decreases from the outermost portion. Here, because current information (boundary condition) applied to the cathode and anode of the SPM of the battery is the same, the amount of Li-ions escaping from the cathode and the amount of Li-ions entering the anode in the SPM are the same as each other.

Also, when the concentration of Li-ions charged in the anode of the battery is divided by $C_{s,max}$ that is the maximum concentration that may enter the SPM and normalized, the SOC is obtained. In other words, in order to normalize the concentration of Li-ions in the anode, this value is divided by $C_{s,max}$, which is the maximum concentration of Li-ions to be used in the model. However, in the cathode of the battery, because the Li-ions escape from the cathode, it has to be simulated that the concentration is lowered as the SOC increases, but as shown in FIG. 3, the SOC is also defined based on the amount of Li-ions escaping from the cathode of the battery, that is, it may be considered that the amount of escaping Li-ions increases as the charging is further performed. Thus, the cathode may be also considered identically with the anode. That is, $C_s$ may be defined based on the increase in the concentration at the anode of the battery and may be defined based on the decrease in the concentration at the cathode of the battery. Here, $C_s$ denotes the concentration of Li-ions, $C_{s,p}$ denotes the concentration (mol m$^{-3}$) of Li-ions at the cathode, and $C_{s,n}$ may denote the concentration (mol m$^{-3}$) of Li-ions at the anode.

For example, when it is assumed that the cathode of the battery includes LiCoO$_2$ and the anode of the battery includes C, as the SOC goes from 0% to 100% during charging, Li$_x$C$_6$ increases from x=0 to x=1 at the anode and Li$_y$CoO$_2$ decreases from y=1 to y=0 at the cathode of the battery. In the SPM according to some embodiments, because the concentration of Li-ions in an electrolyte is not considered, the total sum of the concentrations of Li-ions at the cathode and the anode is pertained, and y=1-x may be represented. Therefore, the formulas for the cathode and the anode are expanded based on x, the same formula may be used while considering only the difference between diffusions at the cathode and the anode. Also, when the average concentration in a spherical structure used in the SPM is calculated, values of $\overline{c_{s,p}}$ and $\overline{c_{s,n}}$ that are the average values are equal to the SOC because the currents applied to the cathode and the anode are the same as each other. Here, $\overline{c_{s,p}}$ denotes an average Li-ion concentration (mol m$^{-3}$) of the cathode, and $\overline{c_{s,n}}$ denotes an average Li-ion concentration (mol m$^{-3}$) of the anode.

Also, because the degree of diffusion differs in the cathode and the anode of the battery, the diffusion difference may increase due to various SOCs and temperatures, which results in a variation in cell voltages or in concentration gradient in the single particle. Thus, this may be used to estimate the concentration or potential of the electrolyte on the part of an anode-separator.

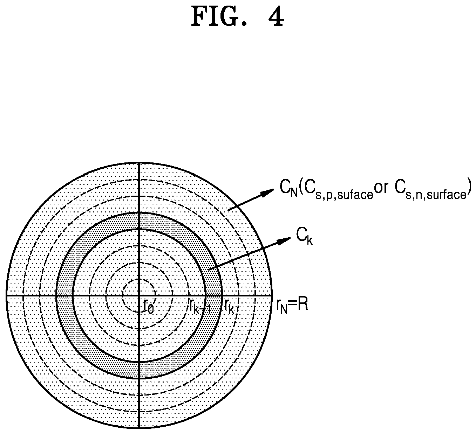

FIG. 4 is a diagram for describing a method of discretizing an SPM of a battery according to some embodiments of the present disclosure.

Referring to FIG. 4, the diagram shows an SPM of the cathode and anode in the battery according to some embodiments, the SPM being discretized into a sphere having a plurality of layers.

Equation 1

$$\frac{\partial c_{s,p}}{\partial t} = \nabla \cdot \left( D_{s,p} \nabla \mathrm{c_{s,p}} \right)$$

Equation 2

$$\frac{\partial c_{s,n}}{\partial t} = \nabla \cdot \left( D_{s,n} \nabla \mathrm{c_{s,n}} \right)$$

where $C_{s,p}$ may denote a Li-ion concentration (mol m$^{-3}$) of the cathode, and $C_{s,n}$ may denote a Li-ion concentration (mol m$^{-3}$) of the anode. Also, $D_{s,p}$ may denote a diffusion coefficient (m$^2$s$^{-1}$) of a cathode particle, and Ds,n may denote a diffusion coefficient (m$^2$s$^{-1}$) of an anode particle.

For example, as shown in FIG. 4, in which the formulae of Equation 1 and Equation 2 above are expanded with respect to each of $C_{s,p}$ and $C_{s,n}$ to estimate the internal state of the battery, the SPM of the battery is divided into N layers a sphere and may be discretized as expressed by Equation 3 and Equation 7 below. In detail, Equation 1 and Equation 2 above may be discretized as expressed by Equation 3 below, and in order to solve Equation 3 below, boundary conditions at opposite ends of a layer have to be identified. Also, because the diffusion may not be further progressed inward in a first layer, as shown in Equation 4 below, the concentration changes according to the boundary condition outside the sphere in an N-th layer (outermost layer)can be expressed as in Equation 5 below. That is, because Equation 6 below is affected by the relationship between the current supplied from the outside and the capacity, when Equation 6 is substituted into Equation 5, Equation 7 below can be obtained.

Equation 3

$$\frac{\partial c_k}{\partial t} = \frac{3}{(r_k{}^3 - r_{k-1}{}^3)} \left[ \left( D_{s,r_k} r_k{}^2 \frac{(C_{k+1} - C_k)}{(r_{k+1} - r_{k-1})/2} \right) - \left( D_{s,r_{k-1}} r_{k-1}{}^2 \frac{(C_k - C_{k-1})}{(r_k - r_{k-2})/2} \right) \right]$$

Equation 4

$$\frac{\partial c_1}{\partial t} = \frac{6D_{s,r_1}}{(r_1 \cdot r_2)}[C_2 - C_1]$$

Equation 5

$$\frac{\partial c_N}{\partial t} = \frac{6}{(R^3 - r_{N-1}{}^3)}\left[ D_{s,R}\left(\frac{R^2}{2}\right)\frac{\partial c}{\partial r}\bigg|_{r=R} - D_{s,r_{N-1}}\left(\frac{r_{N-1}{}^2}{R - r_{N-2}}\right)C_N + D_{s,r_{N-1}}\left(\frac{r_{N-1}{}^2}{R - r_{N-2}}\right)C_{N-1}\right]$$

Equation 6

$$\varphi = -D_{S,R}\frac{\partial c}{\partial r}\bigg|_{r=R} = \frac{I}{\delta A \varepsilon \frac{3}{R} F}$$

Equation 7

$$\frac{\partial c_N}{\partial t} = \frac{6}{(R^3 - r_{N-1}{}^3)}\left[\left(-\frac{R^2 \varphi}{2}\right) - D_{s,r_{N-1}}\left(\frac{r_{N-1}{}^2}{R - r_{N-2}}\right)C_N + D_{s,r_{N-1}}\left(\frac{r_{N-1}{}^2}{R - r_{N-2}}\right)C_{N-1}\right]$$

Here, I denotes a current (A) of a battery, R denotes a radius m of an electrode particle, A denotes an area ($m^2$) of the electrode, $\delta$ denotes a thickness (m) of the electrode, F denotes a Faraday constant (C/mol), and $\varepsilon$ denotes a volume fraction of an active material.

The formulae of Equation 1 and Equation 2 above may be discretized like Equations 3 to 7 and may be expanded with respect to each of the cathode and the anode. Also, $D_{s,r_k}$ is a diffusion coefficient according to the concentration distribution at the cathode and the anode, and is determined according to the concentration and the temperature at the corresponding position.

Equation 8

$$V = OCP_p\left(\overline{c_{s,p}}/c_{s,max}\right) - OCP_n\left(\overline{c_{s,n}}/c_{s,max}\right) + \eta$$

Equation 9

$$\eta = f(OCP_p\left(c_{s,p,surface}/c_{s,max}\right), OCP_n\left(c_{s,n,surface}/c_{s,max}\right), OCP_p\left(\overline{c_{s,p}}/c_{s,max}\right), OCP_n\left(\overline{c_{s,n}}/c_{s,max}\right), R_o, I, T)$$

Equation 10

$$\eta_- = (OCP_p\left(c_{s,p,surface}/c_{s,max}\right) - OCP_n\left(c_{s,n,surface}/c_{s,max}\right)) - (OCP_p\left(\overline{c_{s,p}}/c_{s,max}\right) - OCP_n\left(\overline{c_{s,n}}/c_{s,max}\right)) + I * R_o$$

Equation 11

$$\eta = k_R \frac{\eta_-}{1+|\eta_-|}$$

where $R_o$ denotes a resistance (Ohm), T denotes a temperature (°C or K) of the battery, OCP denotes an open-circuit potential, $OCP_p$ denotes an OCP of the cathode, $OCP_n$ denotes an OCP of the anode, $C_{s,p,surface}$ denotes a lithium concentration (mol m$^{-3}$) of the outermost layer of the cathode, and $C_{S,n,surface}$ denotes a lithium concentration (mol m$^{-3}$) of the outermost layer of the anode. Also, $\overline{c_{s,p}}$ denotes an average lithium concentration (mol m$^{-3}$) of the cathode, and $\overline{c_{s,n}}$ denotes an average lithium concentration (mol m$^{-3}$) of the anode. In addition, $K_R$ may denote an overpotential proportional coefficient.

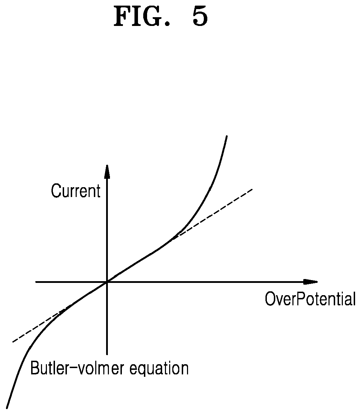

$\eta$ denotes an overpotential. The overpotential denotes a difference between a cell voltage V and the OCV in Equation 8 above, and the cell voltage may be estimated by substituting Equation 9 for Equation 8. However, in the electrochemical model according to some embodiments, the calculated a priori overpotential $\eta_-$ is different from the actual overpotential value $\eta$ because of a Butler-Volmer relationship. For example, in FIG. 5, the Butler-Volmer relationship is shown.

In some embodiments, the relationship between the a priori overpotential $\eta_-$ and the actual overpotential value $\eta$ is generalized in the form of Equation 11 above that may simulate the Butler-Volmer relationship by using the difference between Equation 10 calculated in the electrochemical model and the actually measured cell voltage and the OCV in Equation 8. For example, the overpotential proportional coefficient $K_R$ is an empirical value derived through experiments and an example using a curve fitting. According to some embodiments, the relationship between the current density and the overpotential may be derived by using the relationship between the a priori overpotential $\eta_-$ and the actual overpotential value $\eta$, without iteration between the current density and the overpotential.

Equation 10 above may be derived by using the outermost concentration of the cathode and anode in the battery, average lithium concentration information in the cathode and the anode, and voltage drop (IR drop) information, and the voltage V measured in Equation 8 above and the average lithium concentration information at the cathode and anode may be transformed into the OCP and the relationship with the actual overpotential value $\eta$ may be derived through a curve fitting as expressed by Equation 11 above.

In Equation 8 to Equation 11 above, the OCV according to the SOC may be derived when subtracting the SOC of the cathode OCP and the anode OCP referring to Equation 12 below.

## Equation 12

$$OCP_p\left(\overline{c_{s,p}}/c_{s,max}\right) - OCP_n\left(\overline{c_{s,n}}/c_{s,max}\right) = OCP_p(SOC) - OCP_n(SOC) = OCV(SOC)$$

where $SOC_p = \overline{c_{s,p}}/c_{s,max}$ is a value equal to an average Li-ion concentration escaping from the cathode divided by the maximum concentration, that is, SOC of the cathode. Also, $SOC_n = \overline{c_{s,n}}/c_{s,max}$ is a value equal to an average Li-ion concentration entering the anode divided by the maximum concentration, that is, SOC of the anode. Also, because both cathode and anode are single particles in $SOC_p = SOC_n = SOC$, the cathode SOC and the anode SOC are equal to each other, that is, SOC.

In Equation 8 above, in which $\eta$ (overpotential) is defined as a difference between the measured cell voltage V and the voltage OCV when being stabilized, the overpotential may be obtained by subtracting the voltage of OCV from the measured cell voltage V. In addition, the relationship between the overpotential and the a priori overpotential $\eta_-$ of Equation 10 above may be represented graphically, with the graphical data being obtained through experiments. Curve fitting is then performed to simulate the Butler-Volmer equation, the formula such as Equation 12 above and $K_R$ (overpotential proportional coefficient) may be calculated. For example, the overpotential proportional coefficient may be calculated by using a sigmoid function, a logistic function, a hyperbolic tangent, arctangent, an algebraic function, or any other suitable means.

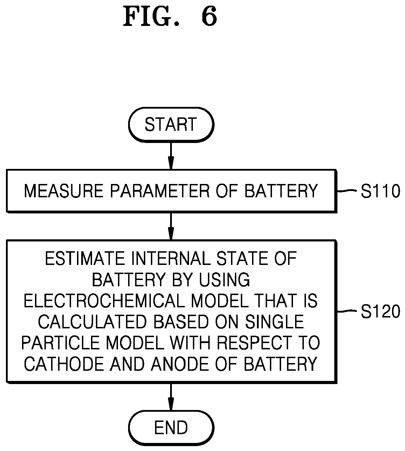

FIG. 6 is a flowchart for describing a method of estimating an internal state of a battery according to some embodiments of the present disclosure. The method of estimating the internal state of the battery, according to some embodiments, may be performed by the processor 150 shown in FIG. 1. Here, the processor 150 may estimate the internal state of the battery by using an electrochemical model that is calculated based on an SPM with respect to a cathode and an anode of the battery based on at least one parameter of the battery.

Referring to FIG. 6, in operation S110, the processor 150 may be configured to obtain at least one parameter of the battery. For example, the at least one parameter may include at least one of a voltage, a current, and a temperature of the battery.

In operation S120, the processor 150 may estimate the internal state of the battery by using an electrochemical model that is calculated based on an SPM with respect to a cathode and an anode of the battery based on at least one parameter of the battery.

The electrochemical model according to some embodiments includes a model that calculates inner Li-ion concentrations in the cathode and anode based on the difference between the diffusion of the Li-ions in the cathode and anode of the battery and estimates the internal state of the battery by using the difference between the Li-ion concentrations in the cathode and anode.

Also, the electrochemical model according to some embodiments includes a model that calculates the inner Li-ion concentrations in the cathode and anode of the battery by discretizing the SPMs with respect to the cathode and the anode of the battery into spheres each having a plurality of layers.

Also, the electrochemical model according to some embodiments includes a model that calculates the inner Li-ion concentrations in the cathode and anode of the battery by using diffusion coefficients according to the concentration distributions in the cathode and anode of the battery.

The diffusion coefficient according to some embodiments is determined according to a concentration and a temperature of each layer from among the plurality of layers in the SPMs of the cathode and anode of the battery.

Also, the electrochemical model according to some embodiments includes a model that estimates the voltage of the battery based on the overpotential value that is the difference between the measured voltage of the battery and the OCV of the battery.

Also, the electrochemical model according to some embodiments includes a model that calculates the a priori overpotential value by using information about the Li-ion concentration in the outermost layer from among the plurality of layers in the SPMs of the cathode and anode of the battery, information about an average Li-ion concentration in the cathode and anode of the battery, and IR drop information of the battery.

Also, the electrochemical model according to some embodiments includes a model that calculates the overpotential value by using the a priori overpotential value and the overpotential proportional coefficient determined in advance.

Also, the a priori proportional coefficient determined in advance according to some embodiments is an empirical value that simulates the relationship between the a priori overpotential value and the overpotential value in a Butler-Volmer equation by using curve fitting.

According to some embodiments of the present disclosure, the battery model is a single particle type electrochemical model that is a reduced calculation model (reduced order model) which is mainly affected by the diffusion in the solid particle as compared with the diffusion of the electrolyte, and a parameter of the model may be expressed by the diffusion and resistance of the cathode and anode.

Also, the battery model according to some embodiments derives a surface SOC that is similar to the calculation of surface Li-density of the electrochemical model, even in the case of an equivalent model.

Also, the battery model according to some embodiments of the present disclosure derives Li-density information in the cathode and anode based on (e.g., in consideration of) the diffusion difference between the cathode and the anode.

Also, the battery model according to some embodiments is expanded to provide a model that estimates the concentration and potential of the electrolyte by using Li-density distributions in the cathode/anode generated due to the diffusion difference between the cathode/anode and difference in the Li-density information between and cathode/anode, and as such, estimates the potential at a certain position (e.g., anode potential at the anode-separation portion).

Various embodiments described herein are examples and are not merely intended to be embodied independently from one another. That is, at least some of the embodiments described herein may be embodied in combination with one another.

One or more of the above embodiments may be implemented in the form of a computer program that may be run in and/or executed by a computer through various elements, and the computer program may be recorded on a non-transitory computer-readable recording medium. Here, the medium may permanently (e.g., continuously) store the computer-executable program or temporarily store the computer-executable program for execution or downloading. In addition, the medium may be various recording units or storage units in the form of a single or several pieces of hardware combined with one another, and is not limited to a medium directly connecting to a certain computer system, but may be distributed over a network. Examples of the non-transitory computer-readable recording medium include magnetic media (e.g., hard disks, floppy disks, and magnetic tapes), optical media (e.g., CD-ROMs and DVDs), magneto-optical media (e.g., floptical disks), and devices configured to store program instructions including ROMs, RAMs, flash memories. Also, examples of another medium may include a recording medium or storage medium maintained by application stores distributing applications or sites, servers, etc. providing or distributing various software.

In addition, the terms such as "... unit", "module", etc. provided herein may be realized by a hardware component such as a processor or a circuit, and/or a software component executed via a hardware component such as a processor. For example, a "unit" and "module" may be realized by, by way of example, components, such as software components, object-oriented software components, class components and task components, processes, functions, attributes, procedures, subroutines, segments of program code, drivers, firmware, microcode, circuitry, data, databases, data structures, tables, arrays, and variables.

The above description of the disclosure is provided for the purpose of illustration, and it would be understood by those skilled in the art that various suitable changes and modifications may be made without changing technical conception and essential features of the disclosure. Thus, embodiments of the present disclosure set forth herein or shown above are to be interpreted in an illustrative and non-limiting sense. For example, each component described to be of a single type can be implanted in a distributed manner. Likewise, components described to be distributed can be implanted in a combined manner.

According to some embodiments, based on the SPM representing the active materials in the cathode and anode of the battery respectively as one spherical structure, the internal state of the battery may be estimated while addressing the limitation in the cell voltage simulation which is caused due to the lithium-ion concentration of the electrolyte at the region with a large current. However, the scope of one or more embodiments is not limited to the above effects.

The terminology used herein is for the purpose of describing particular embodiments and is not intended to be limiting of the inventive concept. As used herein, the singular forms "a" and "an" are intended to include the plural forms as well, unless the context clearly indicates otherwise. It will be further understood that the terms "include," "including," "comprises," "comprising," "has," "have," and "having," when used in this specification, specify the presence of stated features, integers, steps, operations, elements, and/or components, but do not preclude the presence or addition of one or more other features, integers, steps, operations, elements, components, and/or groups thereof.

As used herein, the term "and/or" includes any and all combinations of one or more of the associated listed items. For example, the expression "A and/or B" denotes A, B, or A and B. Expressions such as "one or more of" and "at least one of," when preceding a list of elements, modify the entire list of elements and do not modify the individual elements of the list. For example, the expression "one or more of A, B, and C," "at least one of A, B, or C," "at least one of A, B, and C," and "at least one selected from the group consisting of A, B, and C" indicates only A, only B, only C, both A and B, both A and C, both B and C, or all of A, B, and C.

Further, the use of "may" when describing embodiments of the inventive concept refers to "one or more embodiments of the inventive concept." Also, the term "exemplary" is intended to refer to an example or illustration.

It will be understood that when an element or layer is referred to as being "on", "connected to", "coupled to", or "adjacent" another element or layer, it can be directly on, connected to, coupled to, or adjacent the other element or layer, or one or more intervening elements or layers may be present. When an element or layer is referred to as being "directly on," "directly connected to", "directly coupled to", "in contact with", "in direct contact with", or "immediately adjacent" another element or layer, there are no intervening elements or layers present.

As used herein, the term "substantially," "about," and similar terms are used as terms of approximation and not as terms of degree, and are intended to account for the inherent variations in measured or calculated values that would be recognized by those of ordinary skill in the art.

As used herein, the terms "use," "using," and "used" may be considered synonymous with the terms "utilize," "utilizing," and "utilized," respectively.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims.

**Claims**

1. A method of estimating an internal state of a battery, the method comprising:

   acquiring at least one parameter of the battery; and
   estimating the internal state of the battery by using an electrochemical model based on the at least one parameter, the electrochemical model being calculated based on a single particle model (SPM) with respect to a cathode and an anode of the battery ,
   wherein the electrochemical model comprises a model configured to calculate inner lithium-ion concentrations in the cathode and the anode based on a difference between diffusion of lithium ions in the cathode and the anode of the battery and to estimate the internal state of the battery based on the difference between the inner lithium-ion concentrations in the cathode and the anode.

2. The method of claim 1, wherein the at least one parameter comprises at least one of a voltage, a current, and a temperature of the battery.

3. The method of claim 1 or claim 2, wherein the electrochemical model comprises a model configured to calculate inner lithium-ion concentrations in the cathode and the anode of the battery by discretizing the SPM with respect to the cathode and the anode of the battery into spheres each having a plurality of layers.

4. The method of claim 3, wherein the electrochemical model comprises a model configured to calculate the inner lithium-ion concentrations in the cathode and the anode of the battery based on a diffusion coefficient according to concentration distributions in the cathode and the anode of the battery, and
wherein the diffusion coefficient is based on a concentration and a temperature of each layer from among the plurality of layers in the SPMs for the cathode and the anode of the battery.

5. The method of claim 3 or claim 4, wherein the electrochemical model comprises a model that estimates a voltage of the battery based on an overpotential value defined as a difference between a measured voltage of the battery and an open-circuit voltage (OCV) of the battery.

6. The method of claim 5, wherein the electrochemical model comprises a model configured to calculate an a priori overpotential value based on information about lithium-ion concentration in an outermost layer from among the plurality of layers in the SPMs of the cathode and the anode of the battery, information about an average lithium-ion concentration in the cathode and the anode of the battery, and voltage drop information of the battery, and to calculate the overpotential value based on the a priori overpotential value and an overpotential proportional coefficient.

7. The method of claim 6, wherein the overpotential proportional coefficient is an empirical value that simulates a relationship between the a priori overpotential value and the overpotential value in a Butler-Volmer equation by using curve fitting.

8. A computer-readable program stored in a recording medium for executing the method according to any preceding claim by using a computing device.

9. An apparatus for estimating an internal state of a battery, the apparatus comprising:

a memory configured to store data that is generated by measuring at least one parameter of the battery; and
a processor configured to estimate the internal state of the battery by using an electrochemical model that is calculated based on a single particle model (SPM) with respect to a cathode and an anode of the battery based on the at least one parameter,
wherein the electrochemical model comprises a model configured to calculate inner lithium-ion concentrations in the cathode and the anode based on a difference between diffusion of lithium ions in the cathode and the anode of the battery and estimates the internal state of the battery based on the difference between the inner lithium-ion concentrations in the cathode and the anode.

10. The apparatus of claim 9, wherein the at least one parameter comprises at least one of a voltage, a current, and a temperature of the battery.

11. The apparatus of claim 9 or claim 10, wherein the electrochemical model comprises a model configured to calculate inner lithium-ion concentrations in the cathode and the anode of the battery by discretizing the SPM with respect to the cathode and the anode of the battery into spheres each having a plurality of layers.

12. The apparatus of claim 11, wherein the electrochemical model comprises a model configured to calculate the inner lithium-ion concentrations in the cathode and the anode of the battery based on a diffusion coefficient according to concentration distributions in the cathode and the anode of the battery, and
wherein the diffusion coefficient is based on a concentration and a temperature of each layer from among the plurality of layers in the SPM for the cathode and the anode of the battery.

13. The apparatus of claim 11 or claim 12, wherein the electrochemical model comprises a model configured to estimate a voltage of the battery based on an overpotential value that is a difference between a measured voltage of the battery and an open-circuit voltage (OCV) of the battery.

14. The apparatus of claim 13, wherein the electrochemical model comprises a model configured to calculate an a priori overpotential value based on information about lithium-ion concentration in an outermost layer from among the plurality of layers in the SPMs of the cathode and the anode of the battery, information about an average lithium-ion concentration in the cathode and the anode of the battery, and voltage drop information of the battery, and to calculate the overpotential value by using the a priori overpotential value and an overpotential proportional coefficient.

15. The apparatus of claim 14, wherein the overpotential proportional coefficient is an empirical value that simulates a relationship between the a priori overpotential value and the overpotential value in a Butler-Volmer equation by using curve fitting.

# FIG. 1

# FIG. 2

FIG. 3

# FIG. 4

$C_N (C_{s,p,suface}$ or $C_{s,n,surface})$

$C_k$

$r_0$   $r_{k-1}$   $r_k$   $r_N = R$

# FIG. 5

Current

OverPotential

Butler-volmer equation

# FIG. 6

```
        ┌─────────┐
        │  START  │
        └─────────┘
             │
             ▼
┌──────────────────────────────┐
│  MEASURE PARAMETER OF BATTERY │──── S110
└──────────────────────────────┘
             │
             ▼
┌──────────────────────────────┐
│    ESTIMATE INTERNAL STATE OF │
│        BATTERY BY USING       │
│  ELECTROCHEMICAL MODEL THAT IS│──── S120
│   CALCULATED BASED ON SINGLE  │
│  PARTICLE MODEL WITH RESPECT TO│
│   CATHODE AND ANODE OF BATTERY│
└──────────────────────────────┘
             │
             ▼
        ┌─────────┐
        │   END   │
        └─────────┘
```

| | | Europäisches Patentamt European Patent Office Office européen des brevets | **EUROPEAN SEARCH REPORT** | **Application Number** EP 23 21 2070 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 10 566 811 B2 (SAMSUNG ELECTRONICS CO LTD [KR]; UNIV OXFORD INNOVATION LTD [GB]) 18 February 2020 (2020-02-18) * figures 1-5 * * column 1, line 64 - column 24, line 16 * ----- | 1-15 | INV. G01R31/367 H01M10/48 H01M10/63 H01M10/633 |
| A | US 2022/011370 A1 (KIM GEUM-BEE [KR] ET AL) 13 January 2022 (2022-01-13) * figures 1-8 * * paragraph [0017] - paragraph [0255] * ----- | 1-15 | |
| A | CN 114 545 265 A (SHANGHAI ROSUKENG ENERGY STORAGE SCIENCE AND TECH LIMITED COMPANY) 27 May 2022 (2022-05-27) * figures 1-12 * ----- | 1-15 | |
| A | ZHANG DONG ET AL: "Beyond Battery State of Charge Estimation: Observer for Electrode-Level State and Cyclable Lithium With Electrolyte Dynamics", IEEE TRANSACTIONS ON TRANSPORTATION ELECTRIFICATION, IEEE, vol. 9, no. 4, 13 July 2022 (2022-07-13), pages 4846-4861, XP011956221, DOI: 10.1109/TTE.2022.3191136 [retrieved on 2022-07-14] * page 4848 - page 4859 * ----- | 1-15 | TECHNICAL FIELDS SEARCHED (IPC) G01R H01M |

The present search report has been drawn up for all claims

| Place of search Munich | Date of completion of the search 4 June 2024 | Examiner Zimmermann, Frank |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
...................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 2070

This annex lists the patent family members relating to the patent documents cited in the above-mentioned European search report.
The members are as contained in the European Patent Office EDP file on
The European Patent Office is in no way liable for these particulars which are merely given for the purpose of information.

04-06-2024

| Patent document cited in search report | | Publication date | Patent family member(s) | | Publication date |
|---|---|---|---|---|---|
| US 10566811 | B2 | 18-02-2020 | NONE | | |
| US 2022011370 | A1 | 13-01-2022 | KR | 20220007028 A | 18-01-2022 |
| | | | US | 2022011370 A1 | 13-01-2022 |
| CN 114545265 | A | 27-05-2022 | CN | 114545265 A | 27-05-2022 |
| | | | US | 2023280404 A1 | 07-09-2023 |

EPO FORM P0459

For more details about this annex : see Official Journal of the European Patent Office, No. 12/82